(19) Europäisches Patentamt
European Patent Office
Office européen des brevets

(11) **EP 2 503 696 B1**

(12) **EUROPEAN PATENT SPECIFICATION**

(45) Date of publication and mention
of the grant of the patent:
**23.10.2013 Bulletin 2013/43**

(51) Int Cl.:
*H03M 1/12* (2006.01)     *H03M 1/06* (2006.01)
*H03M 1/08* (2006.01)     *H03M 1/10* (2006.01)

(21) Application number: **12172967.7**

(22) Date of filing: **30.06.2006**

(54) **Time-interleaved analog-to-digital converter system**

Zeitverschachteltes Analog-Digital-Wandlersystem

Système convertisseur analogique-numérique à entrelacement temporel

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**26.09.2012 Bulletin 2012/39**

(62) Document number(s) of the earlier application(s) in accordance with Art. 76 EPC:
**06747981.6 / 2 041 873**

(73) Proprietor: **Signal Processing Devices Sweden AB 583 30 Linköping (SE)**

(72) Inventors:
• **Löwenborg, Per
585 97 Linköping (SE)**
• **Johansson, Håkan
583 34 Linköping (SE)**

(74) Representative: **Valea AB
Teknikringen 10
583 30 Linköping (SE)**

(56) References cited:
**WO-A1-01/99282     WO-A1-2004/079917
US-A- 5 991 622**

• **EKLUND J-E ET AL: "Blind Adaptive Equalization of Mismatch Errors in a Time-Interleaved A/D Converter System", IEEE TRANSACTIONS ON CIRCUITS AND SYSTEMS PART I: REGULAR PAPERS, IEEE SERVICE CENTER, NEW YORK, NY, US LNKD- DOI:10.1109/TCSI.2003.821300, vol. 51, no. 1, 1 January 2004 (2004-01-01), pages 151-158, XP011105432, ISSN: 1057-7122**

EP 2 503 696 B1

**Description**

<u>TECHNICAL FIELD</u>

The invention relates to a method and system for estimating errors introduced in a time-interleaved analog-to-digital converter system.

<u>BACKGROUND OF THE INVENTION</u>

Due to its robustness and precision digital signal processing (DSP) has replaced analog signal processing (ASP) in most technical fields of today, which has enabled the development of information systems such as mobile communication systems and sophisticated medical aids etc. However, the real world is analog by nature, and there is therefore an increasing need for high performance analog-digital interfaces (ADI's), typically realized by a conventional analog-to-digital converter (ADC). Such ADCs are required in almost all signal processing and communication systems and they are often one of the most critical components, i.e., they tend to determine the overall system performance.

Analog- to- digital conversion can be viewed as a uniform sampling followed by a quantization (truncating or rounding the value) . The resolution of an ADC is the number of bits used in the quantization and the data rate of an ADC is the number of samples produced per second on average. Hence, a sampling period of *e.g.* T gives a data rate or sampling rate of 1/T.

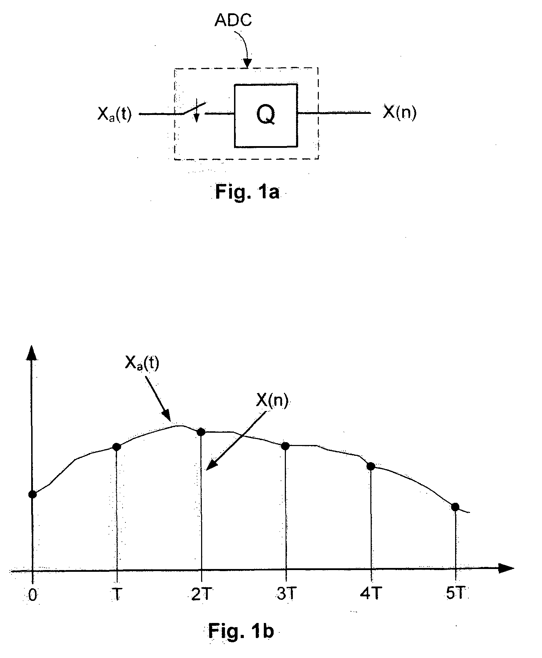

Figure 1a and 1b illustrate an exemplifying analog-to-digital conversion wherein a sequence $X(n)$ is obtained from an analog signal $X_a(t)$ by sampling the latter equidistantly at $t = nT$, i.e., $X(n) = X_a(nT)$, followed by quantization.

There are several existing analog-to-digital conversion techniques, which can be grouped into categories such as flash, pipelined, successive-approximation, integrating, and oversampling sigma-delta converters. The ADC performance is mainly described in terms of sampling rate, resolution, and power consumption.

Previously, ADCs have been good enough for their purposes, but their limitations are now becoming problematic since their capacity does no longer match the rapid development of digital technology. The situation is getting worse as semiconductor process feature sizes are decreasing and data rate requirements of information processing systems increase, since for ADCs, the achievable resolution is highly dependent on the conversion rate. Initially, the progress in analog- to- digital converter development was due to new and better analog circuit topologies and technologies. However, during the past decade, it has become evident that additional major performance improvements most likely cannot be achieved by further progress in topologies and technologies alone. For example, during the last decade, only some 1.5-2 bits of resolution improvement has been achieved for a given speed performance.

In all ADC architectures and technologies known today it is very difficult to simultaneously achieve high resolution and high sampling rate. Such speed/resolution trade-offs are very common in analog circuit design. Resolution is to a large extent determined by matching accuracy of physical devices. For example, in Metal-Oxide Semiconductor (MOS) technology, the variance of the matching error of two devices is a function of the inverse of the device area. Hence, when increasing the area the matching will be improved and the accuracy is increased. However, increasing the area also increases parasitic capacitances of the devices which in general decreases the operational bandwidth of the circuit and thereby reduces the speed.

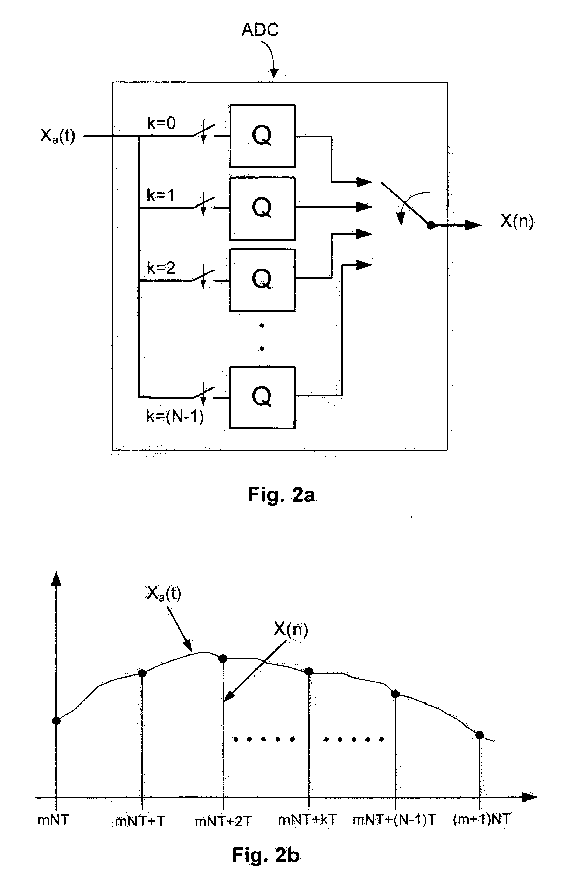

One technique, used since the early eighties, aimed to overcome the speed limitation of high- resolution analog- to- digital conversion is the operation of several ADCs in parallel. The overall ADC system may consist of, say, *N* ADCs. This channelization into N branches enables a reduction of the sampling frequency of each individual converter. Hence, if an effective sampling rate $f_s$ is required, each ADC can work at the reduced sampling *frequency* $f_S$/ *N*. The sampling instants are distributed uniformly in time according to $t_k= (k+mN) T, k=0, 1, ... N- 1$, and $T = 1/f_S$ i.e., the converters are *time- interleaved.* The principle of ideal *N* time- interleaved ADCs is shown in Fig. 2a and 2b.

Using a group of identical ADCs (the ideal case), which is the most commonly selected scheme, the resolution of the overall time-interleaved ADC system is equal to that of each individual converter. In view of the speed/resolution trade-off, the reduction in sampling rate of each converter used in a time-interleaved ADC enables the realization of a higher resolution than what would be possible if a single ADC was to be used. Similarly, if each ADC is being operated at the limit of its speed, the overall ADC sampling rate can be increased beyond what is achievable using a single unit.

However, there are significant problems associated with time- interleaved ADCs. Besides performance degrading effects common to all ADCs, such as for example random variations to the location of the sampling instants (sampling jitter), sample- and- hold circuit nonlinearity, comparator metastability, and nonuniform quantization (static nonlinearity), new errors limit the achievable resolution. The former degradations are consequences of fundamental and inevitable error sources such as fabrication process imperfections, non- symmetric circuit layout, circuit parasitics, and noise. The new errors arise from the parallelization itself and are all introduced by *differences* between the individual ADCs used in the time- interleaved ADC system. These errors are referred to as *channel mismatch errors,* and give rise to nonlinear distortion that degrades the resolution.

As seen in Fig. 2, the subconverters in a time-interleaved ADC system are operated periodically and each ADC is responsible for the task of digitizing every Nth sample. Comparing with the desired behavior of a single ADC, as illustrated in Fig. 1a and 1b, one can see that in order to work properly, a time-interleaved ADC system requires that all sub-converters *behave identically.* If not, the system will not be equivalent to one single ADC working at N times higher sampling frequency.

One channel mismatch error originates from discrepancies in the time instants when each sub-converter is actually taking samples from the analog waveform, i.e. the *aperture delay mismatch. Aperture delay* of an ADC is the time difference between when a sample is supposed to be taken and when the sample is actually taken. In an ADC, the aperture delay varies slightly from sample to sample and this variation is called *aperture jitter.* The aperture jitter of an ADC is, however, in general much shorter than the average aperture delay. Aperture jitter is present in all types of ADCs and is hence not an error specific to time-interleaved ADCs. We will, therefore, not consider the aperture jitter further, but instead focus on the average aperture delay and the damage the average aperture delay of the sub-converters causes to a system of time-interleaved ADCs.

Other harmful channel mismatch errors are first-order gain mismatch and offset mismatch. Like the aperture delay mismatches the distortion caused by these errors must also be eliminated or at least reduced to a satisfactory level.

In order to remove these mismatch errors, the errors between the different ADC:s must first be determined. These errors can then be used to o remove the errors from the digitized signal.

One approach to determine the timing errors in particular is to apply a known calibration signal, and compare the resulting digitized signal with the expected result. An example of this approach is given in the journal paper "A digital-background calibration technique for minimizing timing-error effects in time-interleaved ADC's" by H. Jin and E.K.F. Lee. However, such an approach requires careful timing of input and output, in order to enable a correct comparison, and this makes the method very difficult to implement with high precision.

Instead, it has been proposed to estimate the timing errors from an unknown, but bandlimited signal. One example of such estimation in a parallel ADC is given in WO 04/079917. In the system described in WO 04/079917, the digitized signal can be used to estimate the timing errors, as long as it is band limited to the system bandwidth. However, this requires feedback of the reconstructed signal to the estimator, so that each iteration of the timing error estimation is based on the current reconstruction.

EKLUND J- E ET AL: "Blind adaptive Equalization of Mismatch Errors in a Time- Interleaved A/D Converter System", IEEE TRANSACTIONS ON CIRCUITS AND SYSTEMS PART I: REGULAR PAPERS, IEEE SERVICE CENTER, NEW YORK, NY, US LNKD- DOI: 10.1109/TCSI. 2003.821300, VOL. 51, NO. 1, 1 January 2004 (2004- 01- 01), pages 151- 158, XP011105432, ISSN: 1057- 7122, discloses a method for estimation and compensation of mismatch errors involving time, gain and offset mismatch errors. Also here the errors are estimated using feedback of reconstructed signals.

WO0199282 A1 discloses methods and arrangements for enabling ADCs to be calibrated from reference signals with unknown parameters and/or with amplitudes that exceed the dynamic range of the ADCs, and uses a given analog reference signal supplied to an ADC.

Considering the drawbacks affecting the prior art time-interleaved ADCs it is an object of the present invention to provide estimation of mismatch errors with such precision that no feedback of the reconstructed signal is required. It is a further object to enable reconstruction of a digitized signal by means of an unknown bandlimited signal.

SUMMARY OF THE INVENTION

The present invention obviates or mitigates at least one of the above drawbacks by providing a method according to claims 1-4 and an estimation module according to claims 5-8.

Further advantages of the present invention and embodiments thereof will appear from the following detailed description of the invention.

BRIEF DESCRIPTION OF THE DRAWINGS

Fig. 1a    shows a schematic illustration of a single exemplifying ADC.
Fig. 1b    shows a schematic illustration of an exemplifying analog- to- digital conversion by the ADC in Fig. 1a, whereby a sequence $X(n)$ is obtained from an analog signal $X_a(t)$ by sampling the latter equidistantly at $t = nT$ followed by quantization.
Fig. 2a    shows a schematic illustration of several ADCs as the one in Fig. 1a operated in parallel so as to accomplish a time- interleaved sampling.
Fig. 2b    shows a schematic illustration of an exemplifying analog- to- digital conversion by the ADC in Fig. 1a, whereby a sequence $X(n)$ is obtained from an analog signal $X_a(t)$ by sampling instants distributed uniformly in time according to $t_k = (mNT+kT)$ followed by quantization.

Fig. 3   shows a time- interleaved analog- to- digital converter system.

Fig. 4   shows details in the estimation module of the system in Fig. 3.

Fig. 5   shows a flowchart according to an embodiment of the present invention.

Fig. 6   shows an optimization of a loss- function $F(d_k, G_k, C_k)$ by means of an iterative process.

<u>DETAILED DESCRIPTION OF PREFERRED EMBODIMENTS</u>

*A First Embodiment*

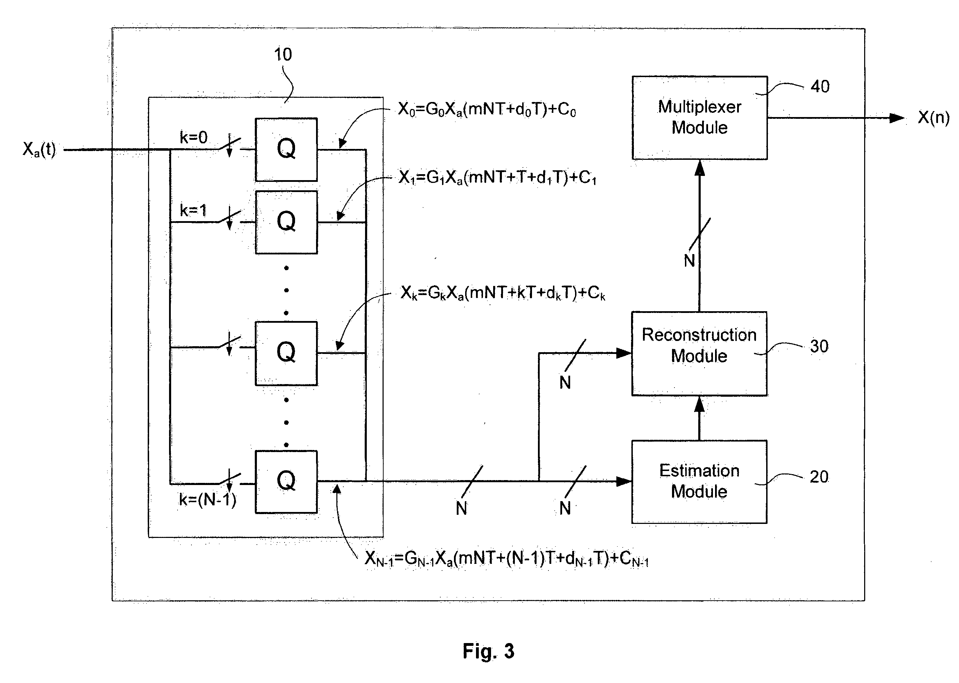

A first exemplifying embodiment of the present invention is illustrated as a general block diagram in Fig. 3, showing a time-interleaved analog-to-digital converter system, which receives an analog input signal $X_a(t)$ and produces a time-interleaved digitized output representation $X(n)$ of said signal.

The exemplifying time-interleaved analog-to-digital converter system in Fig. 3 comprises a time interleaved analog-to-digital module 10 having N parallel and time interleaved analog-to-digital converters arranged to produce N digitized signals:

$$X_0 = G_0 X_a(mNT + d_0 T) + C_0$$

$$X_{N-1} = G_{N-1} X_a(mNT + (N-1)T + d_{N-1}T) + C_{N-1}.$$

As indicated in the background of the invention, the N digitized signals $X_0$ to $X_{N-1}$ produced by a non-ideal time-interleaved analog-to-digital converter are typically comprising relative channel mismatch errors. In particular, a signal $X_k$ of the N digitized signals $X_0$ to $X_{N-1}$ produced by the analog-to-digital converter 10 in Fig. 3 may comprise:

- aperture-delay mismatches $d_k$ ;
- gain mismatches $G_k$ ; and
- offset mismatches $C_k$ .

Where $X_k$ *thus* is expressed according to:

$$X_k = G_k X_a(mNT + kT + d_k T) + C_k$$

To remedy these channel-errors $d_k, G_k, C_k$ the analog-to-digital converter system in Fig. 3 has been provided with an error-estimation module 20 arranged to receive said N digitized signals and to estimate a relative channel-error vector based on these N signals. The system is also provided with a digital reconstruction-filter module 30. The reconstruction-filter module 30 is arranged to receive the N digitized signals and the estimated relative channel-error vector or at least information corresponding thereto. The reconstruction module 30 is further arranged to eliminate or at least reduce the channel-errors based on the estimated relative channel-error vector, so as to generate reconstructed output signals. In addition, to create a reconstructed time-interleaved digitized output signal $X(n)$ the system in Fig. 3 is provided with a multiplexer module 40 arranged to receive and multiplex the N reconstructed output signals from said reconstruction module 30.

The system in Fig. 3 operates in two steps, the estimation phase and the reconstruction phase. In the estimation phase, the relative channel-errors between the different ADC:s are determined. The determined channel-errors are then preferably used to define filter coefficients of the digital reconstruction module 30. This is preferably done in the reconstruction module 30. However, it may alternatively be done in the estimation module 20. Further, in step 2 the digital reconstruction-filter module 30 reconstructs the N digitized signals received from the analog-to-digital module 10, based on said filter coefficients defined in step 1, so as to eliminate or at least reduce the channel-errors. The reconstructed signals are then multiplexed in the multiplexer module 40, which outputs a reconstructed time-interleaved digitized output signal $X(n)$. In the reconstruction phase, the estimation module 20 may be turned off, whereby the system can operate at a lower power.

As is obvious to the man skilled in the art, the analog-to-digital converter system in Fig. 3 may further comprise a controllable input filter module that can be arranged to filter the analog input signal $X_a(t)$ to a bandwidth suitable for both the estimation phase and the reconstruction phase. In the estimation phase the input signal $X_a(t)$ needs to be bandlimited to the Nyquist frequency of a single ADC, and in the reconstruction phase the input signal $X_a(t)$ needs to be bandlimited to the Nyquist frequency of the full system, this to avoid aliasing.

It should be noted that the estimation step and the reconstruction step may be active simultaneously.

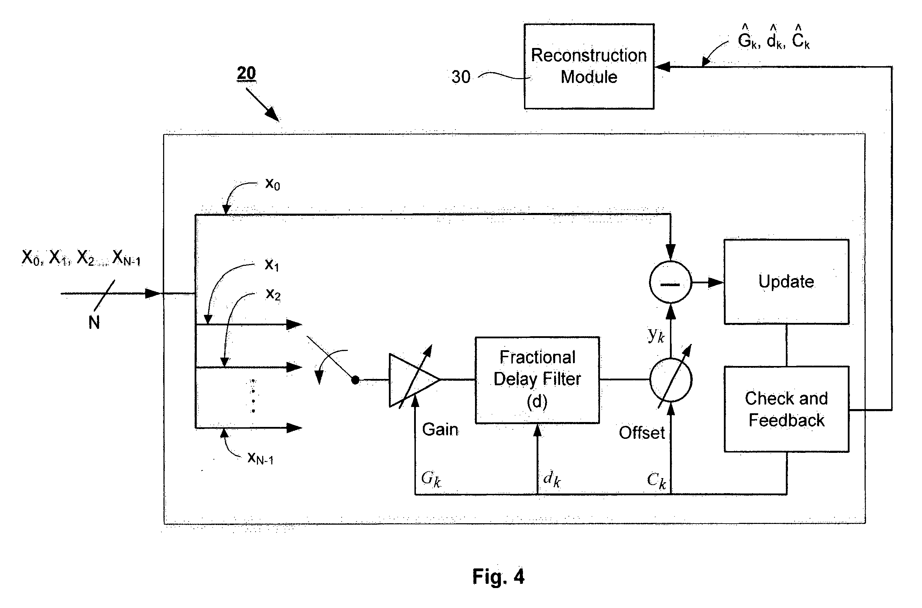

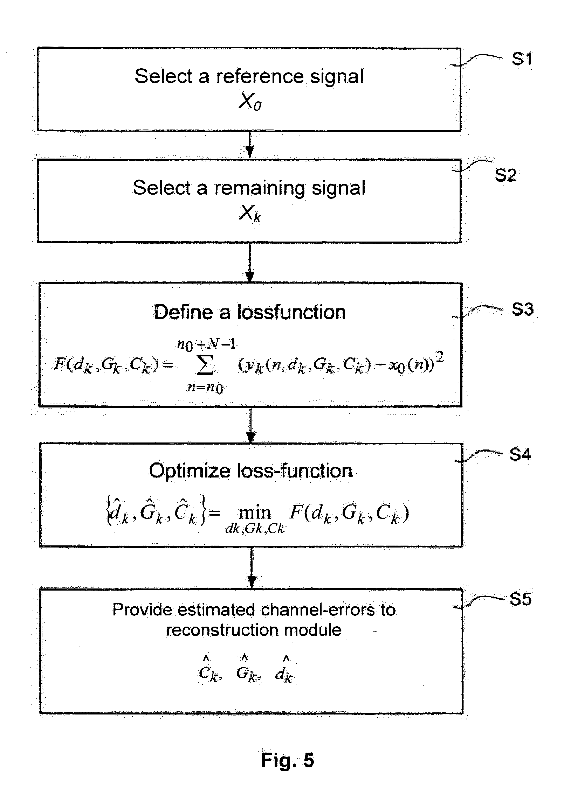

Figure 4 shows the estimation module 20 in more detail. The function of the estimation module 20 will be further explained in connection with the flowchart in Fig. 5. Among the N digitized signals $X_0$ to $X_{N-1}$ entering the estimation module 20 it is preferred that signal $X_0$ is selected as a reference signal provided to a digital subtracter, whereas the remaining signals $X_1$ - $X_{N-1}$ are provided to a multiplexer. The multiplexer is adapted to multiplex the signals $X_1$ - $X_{N-1}$ to a variable amplifier. The amplifier is arranged to amplify or attenuate the signal provided by the multiplexer in a variable fashion depending on a first input steering value, which *e.g.* can be done by means of digital multiplications. The resulting amplified or attenuated signal is provided to a delay filter. The delay filter is arranged to delay the provided signal in a variable fashion depending on a third input steering value. The delay filter is preferably a fractional delay filter (FD- filter) adapted to delay the received signal by fractions of the sampling period T for the analog- to- digital converter 10. It is particular preferred that the fractional delay filter is a Lagrange filter or a Farrow Structure filter or a Thiran Allpass filter. The use of any of these filters for implementing a fractional delay filter is favored, as its filter response will have derivatives with respect to the delay that can be calculated analytically. This also further improves the numerical stability. The resulting delayed signal is provided to a variable offset adjuster. The offset adjuster is arranged to provide an offset to the received signal in a variable fashion depending on a second input steering value, which *e.g.* can be done by means of digital additions and subtractions. The first input steering value corresponds to a variable $G_k$, the second input steering value corresponds to a variable $C_k$ and the third input steering value corresponds to a variable $d_k$.

The resulting signal $y_k (n, d_k, G_k, C_k)$ from the offset adjuster is provided to the above mentioned subtracter, which is adapted to subtract the reference signal $X_0$ from the resulting signal $y_k (n, d_k, G_k, C_k)$. The difference $y_k (n, d_k, G_k, C_k) - X_0$ is squared in a digital squaring module so as to create a loss- function:

$$F(d_k, G_k, C_k) = \sum_{n=n_0}^{n_0+N-1} (y_k(n,d_k,G_k,C_k) - x_0(n))^2 \qquad \text{Eq. 1}$$

The loss- function $F (d_k, G_k, C_k)$ is in turn provided to a minimizer, which is adapted to estimate the channel- errors $\hat{d}_k, \hat{G}_k, \hat{C}_k$ between the reference signal $X_0$ and a signal $X_k$ of the remaining signals, $X_1$ - $X_{N-1}$, as will be further explained below.

Here, it should be emphasized that the order in which the channel- errors are estimated can be more or less freely chosen so as to fit the application in question. Hence, the order in which the channel- errors are given in equations, expressions, text and figures herein should not be taken as determining the order in which they are actually estimated in an operative analog- to- digital converter, unless it is explicitly stated that the order is essential,

Figure 5 shows a flowchart according to an embodiment of the present invention. The flowchart shows a detailed description of the digital signal processing steps performed by the error estimation module 20 in the estimation phase.

The calculations are preferably performed on batches of samples from the N digitized signals $X_0$ - $X_{N-1}$ acquired from the N number of ADC:s in the analog-to-digital module 10. The length of each batch of samples, M, can be selected by the skilled person, but as an example, 1024 samples comprised by a signal $X_0$ - $X_{N-1}$ is considered to be adequate. However, in some embodiments the calculations may be based on single samples of the N digitized signals $X_0$ - $X_{N-1}$. As the method is performed in a sampled system, any time period will be expressed in terms of the sampling period of the system. Therefore, it is important to note that the sampling perrod of the entire system is equal to the interleaving delay T between adjacent ADC:s, whereas the sampling penod of each ADC is NT.

It should be noted, that in the present example the parallelization is used to increase the data rate with maintained resolution, leading to the ADC sampling period NT. However, as the skilled person realizes, in the case where an increase in resolution is desired, the sampling period of each ADC can be shorter than NT, and in the extreme case the same as for the system sampling period, T. This will lead to an over sampled system and a decimation filter will be required on the output signal.

In step S3 of the illustrated example, a loss- function $F (d_k, G_k, C_k)$ is defined as previously described. The loss- function $F (d_k, G_k, C_k)$ represents a relationship- *e.g.* a difference- between a reference signal $X_0$ and the signal $y_k$ to be compared with the reference signal $X_0$. In addition, the loss- function $F (d_k, G_k, C_k)$ it is so defined that it can be easily minimized in order to determine at least one set of estimates $\hat{d}_k, \overline{G}_k, \hat{C}_k$ of the channel- errors $d_k, G_k, C_k$. The

loss- function $F(d_k, G_k, C_k)$ may e.g. comprise a sum of squared values of the differences between the reference signal $X_0$ and the signal $y_k$ to be compared with the reference signal $X_0$ (see Eq. 1 above), or it may *e.g.* comprise a sum of absolute values of the differences between the reference signal $X_0$ and the signal $y_k$ to be compared with the reference signal $X_0$.

In step S1 of the illustrated example, one of the N digitized signals $X_0$ - $X_{N-1}$ is selected as the reference signal $X_0$. Here, it is assumed that the channel-errors $d_0, G_0, C_0$ in the reference signal $X_0$ are zero and that the channel-errors $d_k, G_k, C_k$ in the other remarning signals $X_1$ - $X_{N-1}$ are relative to the channel-errors $d_0, G_0, C_0$ in the reference signal $X_0$. As obvious to those skilled in the art, this will not introduce any limitation since the absolute channel-error is not important when eliminating or reducing the channel mismatch-errors in a time-interleaved analog-to-digital converter. It is likewise obvious to those skilled in the art that any of the signals $X_0$ - $X_{N-1}$ can be selected as a reference signal.

From the above it is recalled that $X_0$ is expressed according to:

$$X_0 = G_0 X_a(mNT + d_0 T) + C_0$$

If no errors are assumed, this thus means that $X_0$ can be expressed according to:

$$X_0 = X_a(mNT)$$

In step S2 of the illustrated example, the signal $X_k$ is selected from the remaining signals $X_1$ - $X_{N-1}$.

From the above it is recalled that $X_k$ may be expressed according to:

$$X_k = G_k X_a(mNT + kT + d_k T) + C_k$$

In step S4 of the illustrated example, the channel- errors $d_k$, $G_k$, $C_k$ are estimated by optimizing the loss-function $F(d_k, G_k, C_k)$, so as to obtain estimates of the channel- errors $\hat{d}_k$, $\hat{G}_k$, $\hat{C}_k$, which in the illustrated example is done by minimizing the function, *i.e.*:

$$\left\{ \hat{d}_k, \hat{G}_k, \hat{C}_k \right\} = \min_{dk, Gk, Ck} F(d_k, G_k, C_k) \qquad \text{Eq. 2}$$

As can be seen from Eq. 2, this is a multivariable minimization. This optimization problem can be solved by conventional techniques, such as Steepest Descend (SD), Conjugated Gradient (CG) or similar. Since the exemplifying loss- function $F(d_k, G_k, C_k)$ in essence is a sum of positive factors- squares in the illustrated example- it ought to be rather smooth, in which case it might suffice with the aforementioned optimization procedures. However, other optimization procedures such as genetic algorithms might also be useful.

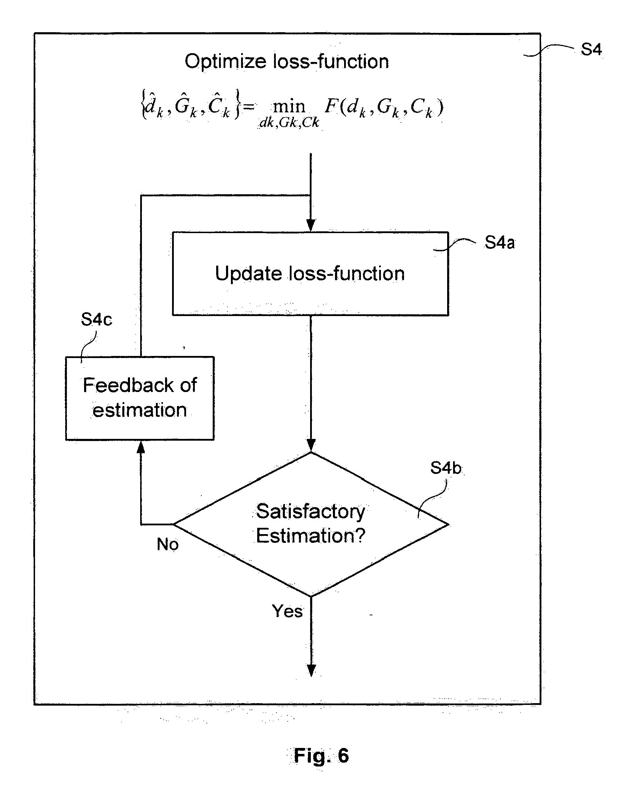

The optimization of the loss- function $F(d_k, G_k, C_k)$ in step S4 is preferably performed by means of an iterative process as schematically illustrated in Fig. 6.

Hence, in step S4a of the illustrated example, the loss- function $F(d_k, G_k, C_k)$ is provided with or updated with a batch of values from the reference signal $X_0$ that was selected in step S2 and a batch of values from the signal $X_k$ that was selected in step S3.

In step S4b of the illustrated example, it is preferred that the estimation is checked. If the estimation is unsatisfactory it is preferred that the method proceeds to step S4c.

In step S4c of the illustrated example, it is preferred that the estimates of the channel-errors $\hat{d}_k$, $\hat{G}_k$, $\hat{C}_k$ are feed back, *i.e.* feed back to the variable amplifier, the variable delay filter and the variable offset adjuster in the estimator 20 respectively. The variable amplifier, the variable delay filter and the variable offset adjuster are then adjusted according to the received estimated channel-errors $\hat{d}_k$, $\hat{G}_k$, $\hat{C}_k$ so as to reduce or eliminate the channel-errors in the signal $X_k$ compared to the reference signal $X_0$.

The variable amplifier, the variable delay filter and the variable offset adjuster being adjusted according to the received estimated channel- errors $\hat{d}_k$, $\hat{G}_k$, $\hat{C}_k$ are then applied to the signal $X_k$. A new set of estimated channel- errors

$\hat{d}_k$ , $\hat{G}_k$ , $\hat{C}_k$ are then obtained in step S4a by providing or updating the loss- function $F (d_k, G_k, C_k)$ with the signal $X_k$ being modified by the adjusted variable amplifier, variable delay filter and variable offset adjuster.

Each such iteration S4a, S4b, S4c can use a new batch of samples of the signal $X_k$ from the analog-to-digital module 10 or work with one single set of samples, depending on the amount of memory available.

In addition, it is preferred that the iterations continue until a satisfactory estimation has been achieved, which may *e.g.* be determined by the number of iterations performed and/or by comparing the previous set of estimated channel-errors with the new set. The optimization procedure may then be terminated when *e.g.* a certain number of iterations have been made and/or when the differences between a previous set and a new set of estimates are small enough.

When the estimation is found to be satisfactory in step S4b it is preferred that the method proceeds to step S5.

In step S5 of the illustrated example, a satisfactory estimation has been achieved and the channel-errors $d_k$, $G_k$, $C_k$ or a suitable representation thereof can be calculated from the final estimation $\hat{d}_k$, $\hat{G}_k$, $\hat{C}_k$ of the channel-errors. The channel-errors $d_k,$ $G_k$, $C_k$ or suitable representations thereof are then provided to the reconstruction module 30.

Suitable reconstruction modules are well known *per se* by those skilled in the art. Typically such reconstruction modules comprises the necessary offset adjuster means, gain adjuster means and time adjuster means, which *e.g.* can be implemented by means of one ore more filter banks. An example descnbing the principles behind such reconstruction modules can be found in the paper "Reconstruction of Nonuniformly Sampled Bandlimited Signals by Means of Time-Varying Discrete-Time FIR Filters", published by Hindawi Publishing Corporation in EURASIP Journal on Applied Signal Processing, Volume 2006, Article ID 64185, page 1-18.

The present invention obviates or mitigates at least one of the above drawbacks by prowling a method for estrmating a plurality of relative channel-error for at least one signal $X_k$ with respect to a reference signal $X_0$, which signals $X_0$ and $X_k$ belong to a group of digitized signals $X_0$-$X_{N-1}$ received by an estimation module from an analog-to-digital module comprising a plurality of parallel and time interleaved analog-to-digital Converters.

The method is performed by said estimation module and comprises the initial steps of:

- defining S3 a function $F (d_k, G_k, C_k)$ representing a relationship between said reference signal $X_0$ and an arbitrary signal $X_k$ in said group of signals $X_0$- $X_{N-1}$;
- selecting S1 a first reference signal $X_0$ in said group of signals $X_0$-$X_{N-1}$;

and the further steps of:

- selecting S2 a second signal $X_k$ from the remaining signals $X_1$ - $X_{N-1}$ in said group; and
- optimizing S4 the function $F (d_k, G_k, C_k)$ *so* as to obtain an estimate $\hat{d}_k$, $\hat{G}_k$, $\hat{C}_k$ or a representation thereof of said plurality of relative channel- error $d_k$, $G_k$, $C_k$ ;
- repeating said further steps for each remaining signal $X_1$-$X_{N-1}$.

As the skilled reader realizes, this includes calculating two channel-errors, calculating three channel-errors and possibly calculating even more channel-errors. The estimated channel-errors are preferably a delay mismatch $d_k$ , a gain mismatch $G_k$ and an offset mismatch $C_k$ or at least two of these. It is likewise obvious to those skilled in the art that any of the signals $X_0$ - $X_{N-1}$ can be selected as a reference signal. In addition, the steps in the method described above must not necessarily be performed in the given order.

It is preferred that the step of optimizing S4 rs performed by an iterative process comprising the steps of:

- feedback of the channel-error or channel-errors estimated in the previous iteration so as to adjust the channel-error in the sequence of the second signal $X_k$ ; and
- updating the function $F (d_k, G_k, C_k)$ with a sequence of the second signal $X_k$ having channel- errors adjusted by said feedback;
- repeating said feedback and said update until a satisfactory estimation is obtained.

Typically, a sequence corresponds to a batch of samples from a digitized signal $X_0$- $X_{N-1}$ received by the estimation module from the analog- to- digital module. However, in some embodiments a sequence be as little as a single sample of the N digitized signals $X_0$ - $X_{N-1}$.

It is also preferred that the method calculates said plurality of estimated channel- errors $\hat{d}_k$, $\hat{G}_k$, $\hat{C}_k$ by defining S1 said function $F (d_k, G_k, C_k)$ as a measure of the difference between said sequences with respect to said plurality of channel- errors $d_k$, $G_k$, $C_k$, and performing an optimization by minimizing S4 the defined function $F (d_k, G_k, C_k)$ .

In another embodiment of the method at least one of the estimated plurality of channel-errors $\hat{d}_k$, $\hat{G}_k$, $\hat{C}_k$ is an estimated delay $\hat{d}_k$ corresponding to an delay mismatch $d_k$, which estimated delay $\hat{d}_k$ is applied to the selected signal $X_k$ using a fractional delay filter.

In still another embodiment of the method said fractional delay filter is implemented using a Lagrange, Farrow Structure or Thiran Allpass.

In a preferred embodiment of the method, the function is defined as:

$$F(d_k, G_k, C_k) = \sum_{n=n_0}^{n_0+N-1} (y_k(n, d_k, G_k, C_k) - x_0(n))^2$$

In addition, the present invention obviates or mitigates at least one of the above drawbacks by providing an estimation module for estimating a plurality of relative channel-errors for at least one signal $X_k$ with respect to a reference signal $X_0$. The signals $X_0$ and $X_k$ belong to a group of digitized signals $X_0$-$X_{N-1}$ produced by an analog-to-digital module comprising a plurality of parallel and time interleaved analog-to-digital converters. The estimation module is arranged to operatively receive said digitized signals $X_0$-$X_{N-1}$ and to operatively select a first reference signal $X_0$ in said group of signals $X_0$-$X_{N-1}$.

The estimation module is characterized by being further arranged to operatively:

- Select a second signal $X_k$ *from* the remaining signals $X_1$-$X_{N-1}$ in said group of signals;
- optimize a function $F(d_k, G_k, C_k)$, representing a relationship between the first signal $X_0$ and the second signal $X_k$ so as to obtain an estimate $\hat{d}_k, \hat{G}_k, \hat{C}_k$ or a representation thereof of said plurality of relative channel- errors $d_k, G_k, C_k$ ;
- repeat said selection and optimizing for each remaining signal $X_1$-$X_{N-1}$ in said group of signals.

As the skilled reader realizes, this includes calculating two channel-errors, calculating three channel-errors and possibly calculating even more channel-errors. The estimated channel-errors are preferably a delay mismatch $d_k$, a gain mismatch $G_k$ and an offset mismatch $C_k$ or at least two of these. It is likewise obvious to those skilled in the art that any of the signals $X_0$ - $X_{N-1}$ can be selected as a reference signal. In addition, the measures taken by the estimation module described above must not necessarily be performed in the given order.

It is preferred that the estimation module is performing said optimizing by being further arranged to operatively:

- feedback the channel-error or channel-errors estimated in the previous iteration so as to adjust the channel-error in the sequence of the second signal $X_k$; and
- update the function $F(d_k, G_k, C_k)$ with a sequence of the second signal $X_k$ having channel- errors adjusted by said feedback;
- repeat said feedback and said update until a satisfactory estimation is obtained.

Typically, a sequence corresponds to a batch of samples from a digitized signal $X_0$- $X_{N-1}$ received by the estimation module from the analog- to- digital module. However, in some embodiments a sequence be as little as a single sample of the N digitized signals $X_0$- $X_{N-1}$.

It is also preferred that the estimation module is characterized by being arranged to operatively calculate said plurality of estimated channel- error $\hat{d}_k, \hat{G}_k, \hat{C}_k$ by utilizing a function $F(d_k, G_k, C_k)$ defining a measure of the difference between said sequences with respect to said plurality of channel- errors $d_k, G_k, C_k$, and by performing an optimization by minimizing the defined function $F(d_k, G_k, C_k)$.

In another embodiment the estimation module is characterized by being arranged to operatively estimate a plurality of channel-errors, wherein at least one of the estimated channel-errors $\hat{d}_k, \hat{G}_k, \hat{C}_k$ is an estimated delay $\hat{d}_k$ corresponding to a delay mismatch $d_k$, and to apply the estimated delay $\hat{d}_k$ to the selected signal $X_k$ using a fractional delay filter.

In stifl another embodiment the estimation module is characterized in that said fractional delay filter is implemented by using a Lagrange, Farrow Structure or Thiran Allpass.

In a preferred embodiment the estimation module is characterized by being adapted to use the function:

$$F(d_k, G_k, C_k) = \sum_{n=n_0}^{n_0+N-1} (y_k(n, d_k, G_k, C_k) - x_0(n))^2$$

Furthermore, the present invention obviates or mitigates at least one of the above drawbacks by providing a system for reducing or eliminating a plurality of relative channel- errors for at least one signal $X_k$ with respect to a

reference signal $X_0$. The signals $X_0$ and $X_k$ belong to a group of digitized signals $X_0$- $X_{N-1}$ produced by an analog- to-digital module comprising a plurality of parallel and time interleaved analog- to- digital converters. The system comprises an estimation module according to any of the embodiments of an estimation module described above. The estimation module is arranged to operatively receive said digitized signals $X_0$- $X_{N-1}$ and to estimate a plurality of relative channel-errors $d_k$, $G_k$, $C_k$. In addition the system comprises a reconstruction module that is characterized by: being arranged to operatively apply said feast one relative channel- error $d_k$, $G_k$, $C_k$, or a representation thereof to said selected signal $X_k$, belonging to a group of digitized signals ($X_0$- $X_{N-1}$) produced by the time interleaved analog- to- digital module, so as to reduce or eliminate the relative channel- errors $d_k$, $G_k$, $C_k$.

The present invention has now been described with reference to exemplifying embodiments. However, the invention is not limited to the embodiment described above. On the contrary, the full extent of the invention is determined by the scope of the appended claims.

**Claims**

1. A method for estimating a plurality of relative channel-errors for at least one signal $X_k$ with respect to a reference signal $X_0$ , wherein the signals $X_0$ , $X_k$ belong to a group of digitized signals $X_0$ - $X_{N-1}$ produced by an analog-to-digital module (10) comprising a plurality of parallel and time interleaved analog-to-digital converters and received by an estimation module;

   said method **characterized by** and performed by said estimation module (20) performing the step of:

   ○ selecting (S1) the reference signal $X_0$ in said group of signals $X_0$ - $X_{N-1}$ ;

   and the further steps of:

   ○ selecting (S2) the signal $X_k$ from the remaining signals $X_1$ - $X_{N-1}$ in said group of signals, wherein the selecting is performed by providing the remaining signals $X_1$ - $X_{N-1}$ including $X_k$ to a multiplexer;
   o defining (S3) a loss function ( F ($d_k$, $G_k$, $C_k$)) representing a difference between said reference signal $X_0$ and a signal $y_k$, wherein

      o the selected signal $X_k$ is provided to a variable amplifier arranged to amplify or attenuate the selected signal $X_k$ in a variable fashion depending on a first input steering value ($G_k$),
      o the resulting amplified or attenuated signal is provided to a delay filter, and
      ○ the resulting delayed signal is provided to a variable offset adjuster arranged to provide an offset to the received signal in a variable fashion depending on a second input steering value ($C_k$),
      ○ whereby the signal $y_k$ is an output signal provided from the offset adjuster; and

   ○ optimizing (S4) the loss function by minimizing the loss function, and there-by obtaining an estimate ($\hat{d}_k$, $\hat{G}_k$, $\hat{C}_k$) of said plurality of relative channel-errors for the signal $X_k$.

2. The method as claimed in claim 1, wherein the method further comprises the step of:

   - repeating said further steps for each one of the other remaining signals ($X_1$-$X_{N-1}$).

3. The method as claimed in any one of claims 1- 2, wherein the loss- function ($F$ ($d_k$, $G_k$, $C_k$) ) comprises a sum of squared values of differences between the reference signal $X_0$ and the signal $y_k$, or comprises a sum of absolute values of differences between the reference signal $X_0$ and the signal $y_k$.

4. The method as claimed in any one of claims 1-3, wherein said relative channel-errors for the selected remaining signal ($X_k$) belong to the group of aperture delay mismatch error, gain mismatch error and offset mismatch error.

5. The method as claimed in any one of claims 1-4, wherein the delay filter is arranged to delay the received signal in a variable fashion depending on a third input steering value, wherein the first input steering value corresponds to a variable $G_k$, the second input steering value corresponds to a variable $C_k$ and the third input steering value corresponds to a variable $d_k$.

6. The method as claimed in claim 5, wherein the loss function F is minimized according to:

$$\left\{\hat{d}_k,\hat{G}_k,\hat{C}_k\right\} = \min_{dk,Gk,Ck} F(d_k,G_k,C_k)$$ , where $\hat{d}_k$, $\hat{G}_k$, $\hat{C}_k$ correspond to said estimate of the plurality of relative channel-errors.

7. The method as claimed in any one of claims 5-6, wherein the loss function is defined as:

$$F(d_k,G_k,C_k) = \sum_{n=n_0}^{n_0+N-1} (y_k(n,d_k,G_k,C_k)-x_0(n))^2 .$$

8. An estimation module (20) for estimating a plurality of relative channel-errors for at least one signal $X_k$ with respect to a reference signal $X_0$, wherein the signals $X_0$, $X_k$ belong to a group of digitized signals $X_0$ - $X_{N-1}$ produced by an analog-to-digital module (10) comprising a plurality of parallel and time interleaved analog-to-digital converters, where said estimation module (20) is arranged to operatively receive said digitized signals $X_0$ - $X_{N-1}$ and to operatively select the reference signal $X_0$ in said group of signals $X_0$ - $X_{N-1}$,
the estimation module (20) **characterized by** comprising:

   ° a multiplexer adapted to select the signal $X_k$ from the remaining signals $X_1 X_{N-1}$ in said group of signals;
   ° a variable amplifier adapted to amplify or attenuate the selected signal $X_k$ provided by the multiplexer in a variable fashion depending on a first input steering value ($G_k$);
   ° a delay filter adapted to delay the amplified or attenuated signal provided by the variable amplifier; and
   ° a variable offset adjuster adapted to provide an offset to the delayed signal provided by the delay filter in a variable fashion depending on a second input steering value ($C_k$),

wherein the estimation module (20) is adapted to optimize a loss function by minimizing the loss function (F ($d_k$, $G_k$, $C_k$) ), so as to obtain an estimate ($\hat{d}_k$, $\hat{G}_k$, $\hat{C}_k$) of said plurality of relative channel- errors for the signal $X_k$, wherein the loss function represents a difference between said reference signal $X_0$ and a signal $y_k$, whereby the signal $y_k$ is an output signal provided from the offset adjuster.

9. The estimation module (20) as claimed in claim 8, being further arranged to:

   repeat said selection and optimizing for each remaining signal ($X_1$-$X_{N-1}$) in said group of signals.

10. The estimation module (20) as claimed in any one of claims 8- 9, wherein the loss- function ($F (d_k, G_k, C_k)$ ) comprises a sum of squared values of differences between the reference signal $X_0$ and the signal $y_k$, or comprises a sum of absolute values of differences between the reference signal $X_0$ and the signal $y_k$.

11. The estimation module (20) as claimed in any one of claims 8-10 wherein said relative channel-errors for the selected remaining signal ($X_k$) belong to the group of aperture delay mismatch error , gain mismatch error and offset mismatch error.

12. The estimation module (20) as claimed in any one of claims 8-11, wherein the delay filter is arranged to delay the received signal in a variable fashion depending on a third input steering value, wherein the first input steering value corresponds to a variable Gk, the second input steering value corresponds to a variable Ck and the third input steering value corresponds to a variable dk.

13. The estimation module (20) as claimed in claim 12, wherein the loss function F is minimized according to:

$$\left\{\hat{d}_k,\hat{G}_k,\hat{C}_k\right\} = \min_{dk,Gk,Ck} F(d_k,G_k,C_k)$$ , where $\hat{d}_k$, $\hat{G}_k$, $\hat{C}_k$ correspond to said estimate of the plurality of relative channel-errors.

14. The estimation module (20) as claimed in any one of claims 12-13, wherein the loss function is defined as:

$$F(d_k . G_k . C_k) = \sum_{n=n_0}^{n_0+N-1} (y_k(n, d_k, G_k, C_k) - x_0(n))^2 .$$

**Patentansprüche**

1. Verfahren zum Schätzen von mehreren relativen Kanalfehlern für mindestens ein Signal $X_k$ in Bezug auf ein Referenzsignal $X_0$, wobei die Signale $X_0$, $X_k$ zu einer Gruppe digitalisierter Signale $X_0$-$X_{N-1}$ gehören, die durch ein Analog/Digital-Modul (10), das mehrere parallele und zeitverschachtelte Analog/Digital-Umsetzer umfasst, erzeugt werden und durch ein Schätzmodul empfangen werden,
wobei das Verfahren gekennzeichnet ist und ausgeführt wird durch das Schätzmodul (20), das den Schritt ausführt:

° Auswählen (S1) des Referenzsignals $X_0$ in der Gruppe der Signale $X_0$-$X_{N-1}$; und die weiteren Schritte:

° Auswählen (S2) des Signals $X_k$ aus den restlichen Signalen $X_1$-$X_{N-1}$ in der Gruppe der Signale, wobei das Auswählen durch Liefern der restlichen Signale $X_1$-$X_{N-1}$ einschließlich $X_k$ an einen Multiplexer ausgeführt wird;
° Definieren (S3) einer Verlustfunktion ($F(d_k, G_k, C_k)$), die einen Unterschied zwischen dem Referenzsignal $X_0$ und einem Signal $y_k$ repräsentiert,
wobei

° das ausgewählte Signal $X_k$ an einen variablen Verstärker geliefert wird, der ausgelegt ist, das ausgewählte Signal $X_k$ auf variable Weise abhängig von einem ersten Eingangssteuerwert ($G_k$) zu verstärken oder zu dämpfen,
° das sich ergebende verstärkte oder gedämpfte Signal an ein Verzögerungsfilter geliefert wird und
° das sich ergebende verzögerte Signal an einen variablen Offset-Einsteller geliefert wird, um an das empfangene Signal auf variable Weise abhängig von einem zweiten Eingangssteuerwert ($C_k$) einen Offset zu liefern,
° wobei das Signal $y_k$ ein Ausgangssignal ist, das von dem Offset-Einsteller geliefert wird; und

° Optimieren (S4) der Verlustfunktion durch Minimieren der Verlustfunktion und dadurch Erhalten einer Schätzung ($\hat{d}_k$, $\hat{G}_k$, $\hat{C}_k$) der mehreren relativen Kanalfehler für das Signal $X_k$.

2. Verfahren nach Anspruch 1, wobei das Verfahren ferner den Schritt umfasst:

Wiederholen der weiteren Schritte für jedes der weiteren restlichen Signale ($X_1$ - $X_{N-1}$).

3. Verfahren nach einem der Ansprüche 1-2, wobei die Verlustfunktion ($F(d_k, G_k, G_k)$) eine Summe von quadrierten Werten der Unterschiede zwischen dem Referenzsignal $X_0$ und dem Signal $y_k$ umfasst oder eine Summe von absoluten Werten der Unterschiede zwischen dem Referenzsignal $X_0$ und dem Signal $y_k$ umfasst.

4. Verfahren nach einem der Ansprüche 1-3, wobei die relativen Kanalfehler für das ausgewählte restliche Signal ($X_k$) zu der Gruppe von Öffnungsverzögerungsfehlanpassungsfehlern, Verstärkungsfehlanpassungsfehlern und Offset-Fehlanpassungsfehlern gehören.

5. Verfahren nach einem der Ansprüche 1-4, wobei das Verzögerungsfilter ausgelegt ist, das empfangene Signal auf variable Weise abhängig von einem dritten Eingangssteuerwert zu verzögern, wobei der erste Eingangssteuerwert einer Variablen $G_k$ entspricht, der zweite Eingangssteuerwert einer Variablen $C_k$ entspricht, und der dritte Eingangssteuerwert einer Variablen $d_k$ entspricht.

6. Verfahren nach Anspruch 5, wobei die Verlustfunktion F minimiert wird gemäß:

$\{\hat{d}_k, \hat{G}_k, \hat{C}_k\} = \min_{d_k, G_k, C_k} F(d_k, G_k, C_k)$, wobei $\hat{d}_k \, \hat{G}_k \, \hat{C}_k$ der Schätzung der mehreren relativen Kanalfehler entsprechen.

7. Verfahren nach einem der Ansprüche 5-6, wobei die Verlustfunktion definiert ist als:

$$F(d_k, G_k, C_k) = \sum_{n=n_0}^{n_0+N-1} (y_k(n, d_k, G_k, C_k) - x_0(n))^2.$$

8. Schätzmodul (20) zum Schätzen von mehreren relativen Kanalfehlern für mindestens ein Signal $X_k$ in Bezug auf ein Referenzsignal $X_0$, wobei die Signale $X_0$, $X_k$ zu einer Gruppe digitalisierter Signale $X_0$-$X_{N-1}$, die durch ein Analog/Digital-Modul (10), das mehrere parallele und zeitverschachtelte Analog/Digital-Umsetzer umfasst, erzeugt werden, wobei das Schätzmodul (20) ausgelegt ist, die digitalisierten Signale $X_0$-$X_{N-1}$ betriebstechnisch zu empfangen und das Referenzsignal $X_0$ in der Gruppe von Signalen $X_0$-$X_{N-1}$ betriebstechnisch auszuwählen,
wobei das Schätzmodul (20) **dadurch gekennzeichnet ist, dass** es umfasst:

° einen Multiplexer, der ausgelegt ist, das Signal $X_k$ aus den restlichen Signalen $X_1$-$X_{N-1}$ in der Gruppe von Signalen auszuwählen;
° einen variablen Verstärker, der ausgelegt ist, das durch den Multiplexer gelieferte ausgewählte Signal $X_k$ auf variable Weise abhängig von einem ersten Eingangssteuerwert ($G_k$) zu verstärken oder zu dämpfen;
° ein Verzögerungsfilter, das ausgelegt ist, das durch den variablen Verstärker gelieferte verstärkte oder gedämpfte Signal zu verzögern; und
° einen variablen Offset-Einsteller, der ausgelegt ist, an das durch das Verzögerungsfilter gelieferte verzögerte Signal auf variable Weise abhängig von einem zweiten Eingangssteuerwert ($C_k$) einen Offset zu liefern,

wobei das Schätzmodul (20) ausgelegt ist, eine Verlustfunktion durch Minimieren der Verlustfunktion ($F(d_k, G_k, C_k)$) zu optimieren, um eine Schätzung ($\hat{d}_k$, $\hat{G}_k$, $\hat{C}_k$) der mehreren relativen Kanalfehler für das Signal $X_k$ zu erhalten, wobei die Verlustfunktion einen Unterschied zwischen dem Referenzsignal $X_0$ und einem Signal $y_k$ repräsentiert, wobei das Signal $y_k$ ein Ausgangssignal ist, das von dem Offset-Einsteller geliefert wird.

9. Schätzmodul (20) nach Anspruch 8, das ferner ausgelegt ist:

die Auswahl und das Optimieren für jedes restliche Signal ($X_1$ - $X_{N-1}$) in der Gruppe der Signale zu wiederholen.

10. Schätzmodul (20) nach einem der Ansprüche 8-9, wobei die Verlustfunktion ($F(d_k, G_k, C_k)$) eine Summe von quadrierten Werten der Unterschiede zwischen dem Referenzsignal $X_0$ und dem Signal $y_k$ umfasst oder eine Summe von absoluten Werten der Unterschiede zwischen dem Referenzsignal $X_0$ und dem Signal $y_k$ umfasst.

11. Schätzmodul (20) nach einem der Ansprüche 8-10, wobei die relativen Kanalfehler für das ausgewählte restliche Signal ($X_k$) zu der Gruppe von Öffnungsverzögerungsfehlanpassungsfehlern, Verstärkungsfehlanpassungsfehlern und Offset-Fehlanpassungsfehlern gehören.

12. Schätzmodul (20) nach einem der Ansprüche 8-11, wobei das Verzögerungsfilter ausgelegt ist, das empfangene Signal auf variable Weise abhängig von einem dritten Eingangssteuerwert zu verzögern, wobei der erste Eingangssteuerwert einer Variablen Gk entspricht, der zweite Eingangssteuerwert einer Variablen Ck entspricht und der dritte Eingangssteuerwert einer Variablen dk entspricht.

13. Schätzmodul (20) nach Anspruch 12, wobei die Verlustfunktion F minimiert wird gemäß
$\{\hat{d}_k, \hat{G}_k, \hat{C}_k\}$ = min$_{dk,Gk,Ck}$ $F(d_k, G_k, C_k)$, wobei $\hat{d}_k$, $\hat{G}_k$, $\hat{C}_k$ der Schätzung der mehreren relativen Kanalfehler entsprechen.

14. Schätzmodul (20) nach einem der Ansprüche 12-13, wobei die Verlustfunktion definiert ist als

$$F(d_k, G_k, C_k) = \sum_{n=n_0}^{n_0+N-1} (y_k(n, d_k, G_k, C_k) - x_0(n))^2.$$

**Revendications**

1. Procédé d'estimation d'une pluralité d'erreurs de canal relatives pour au moins un signal $X_k$ par rapport à un signal de référence $X_0$, dans lequel les signaux $X_0$, $X_k$ appartiennent à un groupe de signaux numérisés $X_0$ - $X_{N-1}$ produits par un module analogique-numérique (10) comprenant une pluralité de convertisseurs analogique-numérique parallèles et entrelacés dans le temps et reçus par un module d'estimation ;
   ledit procédé étant **caractérisé par** et exécuté par ledit module d'estimation (20) exécutant l'étape de:

   - sélection (S1) du signal de référence $X_0$ dans ledit groupe de signaux $X_0$ - $X_{N-1}$ ;

   et les étapes supplémentaires de :

   - sélection (S2) du signal $X_k$ parmi les signaux restants $X_1$ - $X_{N-1}$ dans ledit groupe de signaux, la sélection étant réalisée en fournissant les signaux restants $X_1$ - $X_{N-1}$ comprenant $X_k$ à un multiplexeur ;
   - définition (S3) d'une fonction de perte ($F(d_k, G_k, C_k)$) représentant une différence entre ledit signal de référence $X_0$ et un signal $y_k$, où
   - le signal sélectionné $X_k$ est fourni à un amplificateur variable adapté pour amplifier ou atténuer le signal sélectionné $X_k$ de façon variable en fonction d'une première valeur de commande d'entrée ($G_k$),
   - le signal amplifié ou atténué résultant est fourni à un filtre à retard, et
   - le signal retardé résultant est fourni à un ajusteur de décalage variable adapté pour fournir un décalage au signal reçu d'une façon variable en fonction d'une deuxième valeur de commande d'entrée ($C_k$),
   - le signal $y_k$ étant un signal de sortie fourni par l'ajusteur de décalage ; et
   - l'optimisation (S4) de la fonction de perte en minimisant la fonction de perte, et ainsi, l'obtention d'une estimation ($\hat{d}_k$, $\hat{G}_k$, $\hat{C}_k$) de ladite pluralité d'erreurs de canal relatives pour le signal $X_k$.

2. Procédé selon la revendication 1, dans lequel le procédé comprend en outre l'étape suivante :

   - la répétition desdites étapes supplémentaires pour chacun des autres signaux restants ($X_1$ - $X_{N-1}$).

3. Procédé selon l'une quelconque des revendications 1-2, dans lequel la fonction de perte ($F(d_k, G_k, C_k)$) comprend une somme de valeurs au carré de différences entre le signal de référence $X_0$ et le signal $y_k$, ou comprend une somme de valeurs absolues de différences entre le signal de référence $X_0$ et le signal $y_k$.

4. Procédé selon l'une quelconque des revendications 1 à 3, dans lequel lesdites erreurs de canal relatives pour le signal restant sélectionné ($X_k$) appartiennent au groupe d'erreur de désadaptation de retard d'ouverture, d'erreur de désadaptation de gain et d'erreur de désadaptation de décalage.

5. Procédé selon l'une quelconque des revendications 1 à 4, dans lequel le filtre à retard est adapté pour retarder le signal reçu d'une façon variable en fonction d'une troisième valeur de commande d'entrée, dans lequel la première valeur de commande d'entrée correspond à une variable $G_k$, la deuxième valeur de commande d'entrée correspond à une variable $C_k$ et la troisième valeur de commande d'entrée correspond à une variable $d_k$.

6. Procédé selon la revendication 5, dans lequel la fonction de perte F est minimisée selon :

$$\left\{\hat{d}_k, \ \hat{G}_k, \ \hat{C}_k\right\} = \min_{d_k, \ G_k, \ C_k} \ F\left(d_k, \ G_k, \ C_k\right), \text{ où } \hat{d}_k, \hat{G}_k, \hat{C}_k \text{ correspondent à ladite estimation de}$$

la pluralité d'erreurs de canal relatives.

7. Procédé selon l'une quelconque des revendications 5-6, dans lequel la fonction de perte est définie comme suit :

$$F\left(d_k, \ G_k, \ C_k\right) = \sum_{n=n_0}^{n_0+N-1} \left(y_k(n, \ d_k, \ G_k, \ C_k) - x_0(n)\right)^2.$$

8. Module d'estimation (20) pour estimer une pluralité d'erreurs de canal relatives pour au moins un signal $X_k$ par rapport à un signal de référence $X_0$, dans lequel les signaux $X_0$, $X_k$ appartiennent à un groupe de signaux numérisés

$X_0$ - $X_{N-1}$ produits par un module analogique-numérique (10) comprenant une pluralité de convertisseurs analogique-numérique parallèles et entrelacés dans le temps, où ledit module d'estimation (20) est adapté pour recevoir opérationnellement lesdits signaux numérisés $X_0$ - $X_{N-1}$ et pour sélectionner opérationnellement le signal de référence $X_0$ dans ledit groupe de signaux $X_0$ - $X_{N-1}$,

le module d'estimation (20) étant **caractérisé en ce qu'**il comprend :

- un multiplexeur adapté pour sélectionner le signal $X_k$ parmi les signaux restants $X_1$ - $X_{N-1}$ dans ledit groupe de signaux ;
- un amplificateur variable adapté pour amplifier ou atténuer le signal sélectionné $X_k$ fourni par le multiplexeur de façon variable en fonction d'une première valeur de commande d'entrée ($G_k$) ;
- un filtre à retard adapté pour retarder le signal amplifié ou atténué fourni par l'amplificateur variable ; et
- un ajusteur de décalage variable adapté pour fournir un décalage au signal retardé fourni par le filtre à retard d'une façon variable en fonction d'une deuxième valeur de commande d'entrée ($C_k$),

dans lequel le module d'estimation (20) est adapté pour optimiser une fonction de perte en minimisant la fonction de perte ($F(d_k, G_k, C_k)$), afin d'obtenir une estimation ($\hat{d}_k, \hat{G}_k, \hat{C}_k$) de ladite pluralité d'erreurs de canal relatives pour le signal $X_k$, dans lequel la fonction de perte représente une différence entre ledit signal de référence $X_0$ et un signal $y_k$, moyennant quoi le signal $y_k$ est un signal de sortie fourni par l'ajusteur de décalage.

9. Module d'estimation (20) selon la revendication 8, étant en outre adapté pour : répéter ladite sélection et assurer l'optimisation pour chaque signal restant ($X_1$ - $X_{N-1}$) dans ledit groupe de signaux.

10. Module d'estimation (20) selon l'une quelconque des revendications 8-9, dans lequel la fonction de perte ($F(d_k, G_k, C_k)$) comprend une somme de valeurs au carré de différences entre le signal de référence $X_0$ et le signal $y_k$, ou comprend une somme de valeurs absolues de différences entre le signal de référence $X_0$ et le signal yk.

11. Module d'estimation (20) selon l'une quelconque des revendications 8 à 10, dans lequel lesdites erreurs de canal relatives pour le signal restant sélectionné ($X_k$) appartiennent au groupe d'erreur de désadaptation de retard d'ouverture, d'erreur de désadaptation de gain et d'erreur de désadaptation de décalage.

12. Module d'estimation (20) selon l'une quelconque des revendications 8 à 11, dans lequel le filtre à retard est adapté pour retarder le signal reçu d'une façon variable en fonction d'une troisième valeur de commande d'entrée, dans lequel la première valeur de commande d'entrée correspond à une variable Gk, la deuxième valeur de commande d'entrée correspond à une variable Ck et la troisième valeur de commande d'entrée correspond à une variable dk.

13. Module d'estimation (20) selon la revendication 12, dans lequel la fonction de perte F est minimisée selon :

$$\{\hat{d}_k, \hat{G}_k, \hat{C}_k\} = \min_{dk, Gk, Ck} F(d_k, G_k, C_k)$$ , où $\hat{d}_k \hat{G}_k, \hat{C}_k$ correspondent à ladite estimation de la pluralité d'erreurs de canal relatives.

14. Module d'estimation (20) selon l'une quelconque des revendications 12-13, dans lequel la fonction de perte est définie comme suit :

$$F(d_k, G_k, C_k) = \sum_{n=n_0}^{n_0+N-1} (y_k(n, d_k, G_k, C_k) - x_0(n))^2.$$

ADC

$X_a(t)$ —— Q —— $X(n)$

**Fig. 1a**

$X_a(t)$

$X(n)$

0   T   2T   3T   4T   5T

**Fig. 1b**

ADC

**Fig. 2a**

**Fig. 2b**

**Fig. 3**

$X_0 = G_0 X_a(mNT + d_0 T) + C_0$

$X_1 = G_1 X_a(mNT + T + d_1 T) + C_1$

$X_k = G_k X_a(mNT + kT + d_k T) + C_k$

$X_{N-1} = G_{N-1} X_a(mNT + (N-1)T + d_{N-1} T) + C_{N-1}$

Fig. 4

Fig. 5

Optimize loss-function

$$\{\hat{d}_k, \hat{G}_k, \hat{C}_k\} = \min_{dk,Gk,Ck} F(d_k, G_k, C_k)$$

S4

Update loss-function

S4a

Feedback of estimation

S4c

Satisfactory Estimation?

S4b

No

Yes

**Fig. 6**

20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 04079917 A

- WO 0199282 A1

### Non-patent literature cited in the description

- Blind adaptive Equalization of Mismatch Errors in a Time-Interleaved A/D Converter System. **EKLUND J-E et al.** IEEE TRANSACTIONS ON CIRCUITS AND SYSTEMS PART I: REGULAR PAPERS. IEEE SERVICE CENTER, 01 January 2004, vol. 51, 151-158

- Reconstruction of Nonuniformly Sampled Bandlimited Signals by Means of Time-Varying Discrete-Time FIR Filters. EURASIP Journal on Applied Signal Processing. Hindawi Publishing Corporation, vol. 2006, 1-18